(19) Europäisches Patentamt
European Patent Office
Office européen des brevets

(11) EP 2 702 185 B1

(12) EUROPEAN PATENT SPECIFICATION

(45) Date of publication and mention
of the grant of the patent:
**23.09.2015 Bulletin 2015/39**

(51) Int Cl.:
***C23C 14/32*** *(2006.01)* ***B23B 27/14*** *(2006.01)*

(21) Application number: **11722342.0**

(22) Date of filing: **29.04.2011**

(86) International application number:
**PCT/EP2011/056878**

(87) International publication number:
**WO 2012/146311 (01.11.2012 Gazette 2012/44)**

(54) **METHOD FOR MODIFYING AND ALLOYING SURFACES OF WC BASED HARD METAL STRUCTURES**

VERFAHREN ZUM VERÄNDERN UND LEGIEREN VON OBERFLÄCHEN AUF WC-BASIERTEN HARTMETALLSTRUKTUREN

PROCÉDÉ DE MODIFICATION ET D'ALLIAGE DE SURFACES DE STRUCTURES EN MÉTAL DUR À BASE DE CW

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.03.2014 Bulletin 2014/10**

(73) Proprietors:
• **Urgen, Mustafa**
  **34469 Istanbul (TR)**
• **Sireli, Erdem**
  **34469 Istanbul (TR)**
• **Akkaya, Sinan**
  **34469 Istanbul (TR)**
• **Kazmanli, Kürsat, M.**
  **34469 Istanbul (TR)**

(72) Inventors:
• **Urgen, Mustafa**
  **34469 Istanbul (TR)**
• **Sireli, Erdem**
  **34469 Istanbul (TR)**
• **Akkaya, Sinan**
  **34469 Istanbul (TR)**
• **Kazmanli, Kürsat, M.**
  **34469 Istanbul (TR)**

(74) Representative: **Mutlu, Aydin**
**Invokat Intellectual Property Services**
**Agaoglu My Office 212-D:241**
**Basin Ekspres Yolu Tasocagi**
**Cad. No: 3 Bagcilar**
**34218 Istanbul (TR)**

(56) References cited:
**US-A1- 2009 252 973**

• **YAMAMOTO ET AL: "Structural and mechanical property of Si incorporated (Ti,Cr,Al)N coatings deposited by arc ion plating process", SURFACE AND COATINGS TECHNOLOGY, ELSEVIER, AMSTERDAM, NL, vol. 200, no. 5-6, 21 November 2005 (2005-11-21), pages 1383-1390, XP005173157, ISSN: 0257-8972, DOI: 10.1016/J.SURFCOAT.2005.08.025**
• **CORLU B ET AL: "Surface modification of iron containing aluminum alloys by treatment with copper plasma produced with cathodic arc", SURFACE AND COATINGS TECHNOLOGY, ELSEVIER, AMSTERDAM, NL, vol. 204, no. 6-7, 25 December 2009 (2009-12-25), pages 872-877, XP026770354, ISSN: 0257-8972, DOI: 10.1016/J.SURFCOAT.2009.08.019 [retrieved on 2009-08-24]**

EP 2 702 185 B1

**Description**

**Technical Field of the Invention**

The present invention relates to a method directed to improve wear and corrosion resistance of WC based hard metals, and more particularly, to a method that involves ion bombardment in a cathodic arc physical vapor deposition system for combined diffusion acceleration and surface modification of the hard metals. The invention is also pertaining to a new structure obtainable by the novel method disclosed herewith.

**Background of the Invention**

WC based hardmetals are widely used, for instance as cutting tools, seals and bearings due to their excellent mechanical properties, especially high hardness and wear resistance. They have been the subject of numerous studies aiming to explain and improve their properties. One of the major concerns in WC based or WC containing hard metals is the formation of eta "η" phase which is a carbide phase in the form of $M_3W_3C$ ($M_6C$) or $M_6W_6C$ ($M_{12}C$) (M=Fe, Co...) with very high bulk modulus. The bulk modulus of $M_{12}C$ is 462 GPa, which is greater than that of diamond (436.8 GPa).
Eta phase coexists with WC-Co at around 1280-1450°C, at optimal carbon content, though upon cooling it separates into WC and Co. If no carbon deficiency is present, eta phase is not found at room temperature unless cooled very rapidly. Although, in some application areas, η phase is not wanted in the structure of WC-Co based hard metals, it may be beneficial for the applications where high wear resistance is needed, such as drawing dies. Another area of concern about WC-Co hardmetals tools is corrosion resistance. Since WC-Co has a non-homogeneous composite structure, it suffers from galvanic corrosion. Cobalt binder gets dissolved in an aggressive environment while WC remains mostly unaffected, hence a WC skeleton is left behind which cannot withstand heavy working conditions. It is possible to increase corrosion resistance by controlling the binder amount and WC grain size as for instance disclosed in US 7,384,689, or by addition of $Cr_3C_2$ or substitution of binder metal with Ni and its alloys. However, all of these processes used for increasing the corrosion resistance bring along the risk of reduced toughness.
It was demonstrated in O. Esa et al. International Journal of Refractory Metals & Hard Materials 25 (2007) 286-292 that an eta phase in the form of $Co_3W_3C$ may be formed at the sintering temperature wherein unreacted $Co_3W_3C$ is retained after cooling from said temperature. It was further recited that the formation and microstructure of eta phase depends on the carbon level and temperature.
Another deliberate attempt for obtaining eta phases in cemented carbide was described in US 6,464,748. The carbon content was adjusted to obtain the desired amount of eta phase. The cemented carbide as obtained with the aforementioned process comprised a binder phase consisting of Co, Ni and Mo whereas grain growth inhibitors V and/or Cr were also included.
US 2009/252973 describes a process for the cathodic arc deposition of Al, Cr and Si layers onto WC-Co hard metal substrates for the purpose of improving its wear properties.
However, none of the prior art references cited above provides an easily applicable and efficient way of obtaining eta phases without applying the classical methods such as carbon level adjustment or specific temperature regulations. Further methods of applying certain metals on WC based hard metals, as disclosed for example in JP 63223104 and WO 2007/121954, are purely directed to create a coating layer rather than alloying the surface and improving the corrosion and wear resistance with eta phases.
It is therefore one of the objectives of the present invention to provide a readily applicable method for obtaining hard metal surfaces that do not suffer from the corrosion problems. A further object of the present invention is to provide a readily applicable method for obtaining hard metal surfaces that are substantially wear resistant under heavy working conditions. Still a further object of the present invention is deliberately obtaining the objective eta phases in certain alloys without any effort for changing the carbon content. In more specific embodiments, further objects of the present invention are mainly directed to provide alloyed surfaces on WC based hard metals wherein corrosion and wear resistance problems are substantially eliminated with an effective Cathodic Arc Plasma Treatment (CAPT) method introduced by the inventors.
These and other objects that may be envisaged in light of the following description have been achieved by a novel method as disclosed in claim 1. The method is based on an ion bombardment procedure from a cathodic arc source under a specially designed varying bias regime. When the substrate is biased negatively, the highly ionized nature of the cathodic arc plasma enables the adjustment of bombardment energy which is proportional to the charge state of the ions, and applied bias voltage. With sufficient energy, ion irradiation can cause atoms to rearrange such as in an ion beam mixing process.

**Brief Description of the Figures**

Figure 1 is a diagram for comparison of ramped and staircase bias cycles according to the present invention.

Figure 2 is a diagram showing the temperature profile of a sample that was treated with Cr ion bombardment at -1000V of constant bias for 10 minutes.

Figure 3 shows XRD measurements for (a) untreated K20 hardmetal, (b) samples treated with a 30s -150V/15s -1000V ramped bias cycle for 30 minutes, (c) samples treated under high (-1000V) bias voltage for 10 minutes, (d) samples treated with 12s -150V/9s -1000V staircase bias cycle for 30 minutes.

Figure 4 is a diagram showing temperature measurements for the sample treated with 12s -150V/9s -1000V bias cycles for 30 minutes.

Figure 5 shows temperature vs. time graph for the sample treated with Al plasma using 30s -150V/30s -800V ramped bias cycle for 30 minutes.

Figure 6 shows XRD measurements belonging to untreated and Al plasma treated (30s -150V/30s -800V ramped bias cycle for 30 minutes) K20 samples.

Figure 7 is a SEM micrograph showing the corrosion damage on untreated K20 sample after 24 hours of immersion in a corrosive solution.

Figure 8 is a cross sectional SEM image of the sample that was treated with chromium in 12s/9s staircase bias cycles, after immersion for 24 hours in a corrosive solution.

Figure 9 is a SEM image belonging to the sample treated with Al plasma using 30s - 150V/30s -800V ramped bias cycles for 30 minutes. Image is taken after immersion in corrosive environment for 24 hours. No indication of corrosion damage is present.

**Detailed Description of the Invention**

The main objectives of the present invention as expressed in the background are achieved via treating a hard metal substrate which is a WC based material, with metals selected from Cr, Al, Ti, Mo, Nb, Cu and alloys thereof, in a Cathodic Arc PVD system under varying negative bias voltages so that improved surface characteristics may be attained. The bias regimes applied during the coating procedures of the invention are specifically designed in accordance with nature of the metal ions to be bombarded as well as with the application area of the resulting product. The substrate material as treated according to the procedure of claim 1 may be final products suitable for use in metal industry such as cutting tools, sealings and bearings, or may be a semi-product that is to be processed and shaped into such final products.

In the context of the present invention, the term "varying bias" refers to a special biasing regime applied via cathodic arc evaporation within the range of a low and high bias voltages in a cyclic manner either with a ramped or staircase mode in order to apply coating-bombardment cycles on a sample surface. It is also intended with the term WC based "hard metals" any material substantially consisting of WC along with a metal selected from the group consisting of Co, Ni, Mo and Fe. Said hard metal may further comprise other carbides or carbonitrides such as TiC, TaC, Mo2C, TiCN, (Ti,W)CN. The WC based substrate may refer to a cermet that substantially comprises WC in its structure. The Co, Ni and Mo metals may function as binder agents in order to form the well known hard alloys such as WC-Co and WC-Ni.

While applying different bias regimes within the meaning as defined above with different metals in a CAPT system, the inventors surprisingly noted that such a varying bias regime provides very notable advantages when a substrate of WC based hard metal is bombarded with Cr, Al, Ti, Mo, Nb, Cu or alloys thereof. Firstly, it was observed that under the procedure of the invention, Cr, Ti, Mo and Nb bombardment results in a very prominent eta phase having advantageous properties in terms of wear and corrosion resistance. It was also observed that, treating the WC based substrate with Al and Cu under this procedure advantageously causes better penetration of Al or Cu, and possible formation of Al-Co or Cu-Co intermetallics resulting in improved corrosion resistance although no eta phase occurs in the system.

Eta phase formation in a WC based hardmetal normally occurs in the temperature range of 1200-1450°C. If carbon content is optimal, it dissolves back to WC and Co upon cooling to room temperature (according to reaction 1). In the case of carbon deficiency, retained $\eta$ phase is found at room temperature.

$$WC + liq. \rightarrow WC + \eta + liq. \rightarrow WC + \beta \qquad (1)$$

The $\eta$ phase formed during second step of this reaction (1) is in the form of $M_6C$ since it is the metastable carbide that likely dissociates into WC and $\beta$.

Metastable $M_6C$ may also dissociate into $M_{12}C$ in a very slow rate (reaction 2), which does not allow $M_{12}C$ to appear as $\eta$ phase in the processing of commercial WC-Co hard metals.

$$M_6C \rightarrow M_{12}C + \beta + WC \qquad (2)$$

However, it is known that it is possible to form $M_{12}C$ structures by solid state reactions between WC and Co in cases where highly defective structure are present in the temperature range of 800-1100°C without the need of liquid phase presence. The $\eta$ phase observed in all the samples that were subjected to CAPT is in the form of $M_{12}C$. Formation of the phase $M_{12}C$ during continuous ion bombardment may be attributed to the defective structure created by high voltage bias bombardment and sample temperatures (i.e. in the order of 1200°C) reached during the treatment which are expected to promote the solid state reaction between Co(W,C) and WC. When an accelerated ion collides with surface atoms, a collision cascade may occur depending on the acceleration voltage. The defective structure created by these collision cascades, combined with local hot spots may have a similar effect to mechanical activation, which is known to be favorable for $Co_6W_6C$ formation.

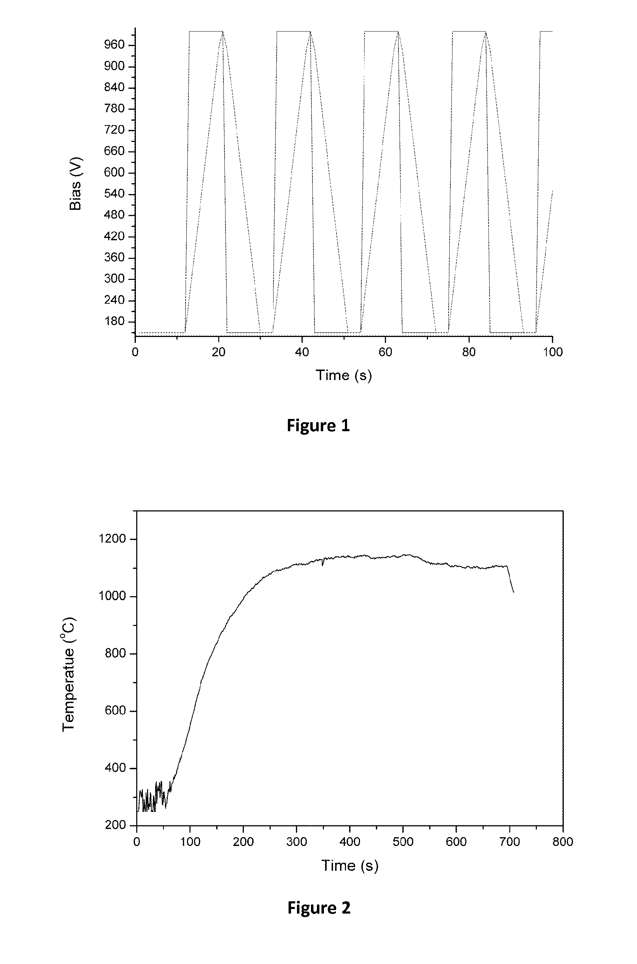

According to a first embodiment of the present invention a WC based material is treated with a suitable metal selected from the group of chromium, titanium, molibdenum and niobium with a ramped or staircase bias mode in a bias range of - 1/-1100V, more preferably of -50/-1000V. In this case, the lowest negative voltage may be in the range of -1/-300V, more preferably of -50/-150V while the highest bias value reached either in the ramped or staircase mode is set to a range between - 500/-1100V, more preferably between -900/-1000 V. An exemplary demonstration and comparison of the ramped and staircase modes are given in Figure 1. According to this embodiment, treatment of the WC based substrate surfaces with Cr, Ti, Mo and/or Nb ions, resulted in a notable amount of $\eta$ phase formation either in the ramped or staircase mode of bias voltage. After CAPT treatment in ramped mode according to the present invention, the formation of n phase was clearly observed in the XRD pattern. The intensity of the highest peak (40.63° 2θ) of n phase in the case of Cr bombardment is measured as 4 in the normalized XRD patterns. However, the intensity of the highest peak (40.41° 2θ) measured for the 10 minute ion bombardment treatment samples was 10. These peaks however indicate that the n phase amount is lower in the case of ramped bias mode. Although the temperature range during ramped treatment (750-800°C) is barely enough for $\eta$ phase formation, the defective structure induced by high bias application may also be effective for this case.

Surprisingly, when the treatment with high-low bias cycles is done in a staircase manner to maintain high sample temperature, the most prominent n phase formation is observed. Highest peak (40.33°2θ) intensity was 25 in the normalized scale. The sample temperature and total bombardment time are very close to those of the 10 minute sole bombardment treatment. The difference between formed $\eta$ phase amounts may be due to an n phase promoting effect from Cr, which possibly diffused into the sample.

According to a second embodiment of the present invention a WC based material is treated with aluminum or copper with a ramped bias mode in a bias range of -1/-1000V, more preferably of -50/-800V. In this case, the lowest negative voltage may be in the range of -1/300V, more preferably of -50/-150V while the highest bias value reached in the ramped mode is set to a range between -500/-1000V, more preferably to a range of -650/-800V. The samples are not desired to reach high temperatures, i.e. above 900°C because of no beneficial effect, hence bias regime is limited to a ramped mode within a relatively low bias range as given above. The lack of n phase formation in the case of Al treated samples is consistent with relatively low process temperatures (700-800°C). Al addition to WC-Co hardmetals may have a $\eta$ phase preventing effect. It was, however noted that varying bias regime in the sense of the present invention is advantageous for improving corrosion resistance of the Al or Cu treated materials.

XRD patterns belonging to Al plasma treated samples construed to have $Al_3Co$ and $Al_{13}Co_4$ phases that have been formed during the treatment according to the present invention. These indications along with the lack of $\eta$ phase formation are confirming the Al diffusion during the treatment. Al and Cu are known to show passivation behavior in acidic environments. Increased corrosion resistance of Al and Cu plasma treated samples may be due to the dissolved Al and Cu in the structure, caused by the cyclic bias application.

In a preferred embodiment of the present invention, all bias adjustments are carried out through a computer enabling manual or automatized changes with preset bias values. In a further embodiment the bias voltages are applied with a pulse power supply that is adapted to exert varying bias modes of the invention within an interval from milliseconds to several seconds. In all embodiments, the coating procedure in a low bias value and bombardment procedure in a high bias value may take several seconds, for instance ranging from milliseconds to 100 seconds whereas the total treatment period with cycles of low and high bias exertion may vary in the range of 5 to 120 minutes, although a total treatment period of 20-30 minutes would be sufficient. In a staircase mode, jumping from the low bias value to the highest bias value may take place in a very short time, i.e. within just 1 second.

In a preferred embodiment of the present invention, the method of treating the hard metals further comprises the step of sputter cleaning and heating of the substrate prior to the main procedure in order to promote formation of the n phase and/or intermetallic layers. For this step, samples are placed in a PVD unit at room temperature. After reaching a base pressure of $5.33 \times 10^{-3}$ Pa the process is started by the consecutive application of -600, -800 and -1000 volts bias for a period of 1 min each, for sputter cleaning and heating of the substrates. No gas input was made into the system for the entire procedure. After heating the substrates, the cyclic deposition and bombardment process were initiated.

Further advantages and alternative embodiments of the present invention may be apparent to those skilled in the art in light of the examples below which are only for illustration purposes, but not limiting the scope of the invention as defined in the appended claims.

## Examples

WC-Co samples (K20 grade), containing 10% Co with an average WC particle size of $3\mu m$ were mirror polished, then ultrasonically cleaned in isopropyl alcohol and acetone for a total of fifteen minutes at room temperature prior to the surface modification procedure. The treatment processes were carried out in a Novatech-SIE, Model: NVT-12 DC cathodic arc PVD (CAPVD) unit using two different programmable power supplies for bias application (ITM ISP 1010, Advanced Energy Pinnacle 12K). All bias adjustments were carried out through computer. The Cr cathode was operated at 60 A and the Al cathode at 45 A.

The samples were placed in the PVD unit at room temperature. After reaching a base pressure of $5.33 \times 10^{-3}$ Pa the process was started by the consecutive application of -600, -800 and -1000 volts bias for a period of 1 min. each, for sputter cleaning and heating of the substrates. No gas input was made into the system for the entire procedure. After heating the substrates, the cyclic deposition and bombardment process was initiated.

For the coating/bombardment cycles with Cr ions, bias voltages of -150V (deposition)/-1000V (bombardment) were applied alternatingly. These values were kept constant in all the experiments, only low/high bias periods were altered. Two different methods, namely the ramped and the staircase modes, were used for changing bias voltages.

When treating with Al ions, chosen bias voltages were -150V for coating periods and -800V for the bombardment periods. Only a 30s -150V/15s -800V ramped bias mode treatment was tested for the Al plasma treatment experiments.

Different deposition and bombardment durations as well as total treatment time were used for the investigation of structural changes that may occur on the substrates. Substrate temperatures were measured and recorded with an infrared pyrometer.

For the investigation of structural changes induced by the CAPT on the substrates, a glancing angle X-Ray diffractometer (PhilipsPW3710) equipped with a thin film attachment was used. Observations were made using $2\theta$ method in the 20-85° range with an incidence angle of 2°, using Cu-K$\alpha$ radiation. Surface and cross-sectional investigations of the specimens were conducted with scanning electron microscopy.

In order to test the corrosion behavior of the surface treated substrates, treated and untreated samples were immersed in 5 vol.% $H_3PO_4$ containing 1g/l $Zn^{+2}$ for 24 hours at 50°C. The extent of corrosion as investigated on the polished cross-sections was observed via SEM.

## Example 1

### Samples treated with Cr plasma under high (-1000V) bias voltage for 10 minutes

An experiment was conducted in order to investigate possible effects of high bias ion bombardment on the structure of K20 samples. The substrate was subjected to Cr ion bombardment under -1000V bias for 10 minutes. During the treatment, sample temperature reached 1100°C in approximately 250 seconds and stayed constant for the entire treatment duration. At the end of the treatment, the samples cooled down to 250°C in 1250 seconds (Fig.2).

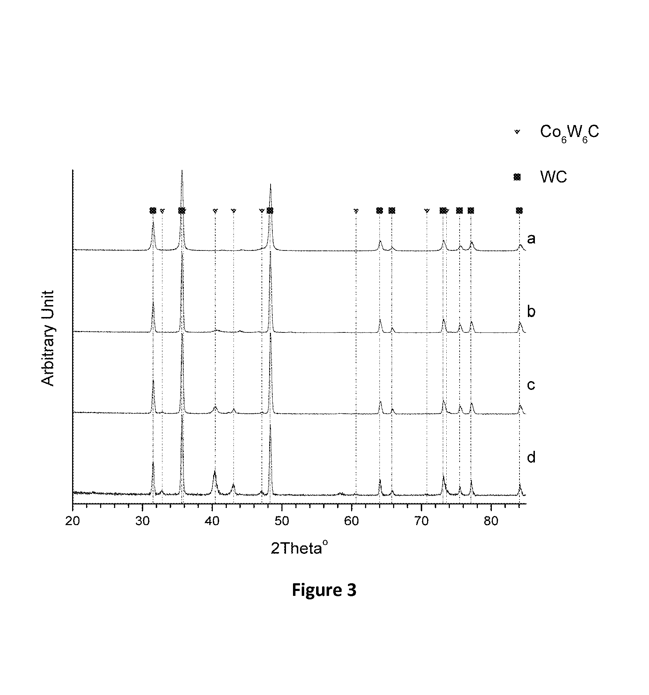

XRD measurements for these samples, given in Fig.3c revealed the presence of $\eta$ carbide $M_{12}C$ within the structure. Also when compared to the untreated sample, it's found that FWHM values for WC peaks decreased with the treatment, indicating an increase in the crystallite sizes of WC.

These results are a clear indication that there is a possibility of η phase formation and grain growth during high bias voltage CAPVD applications on WC-Co hardmetals.

## Example 2

### *Samples treated with Cr plasma using 30s -150V/15s -1000V ramped bias cycle for 30 minutes*

In order to observe the effects of possible Cr diffusion during the CAPT, substrates were subjected to a cyclic bias application. Chromium was allowed to deposit on the samples during the -150V low bias period. After the 30 seconds of coating, bias was increased to -1000V generally with a ramp of 100V per second and held there for the remainder of the bombardment period (15 seconds total). Then bias was decreased to -150V again with a rate generally of 100V per second. After total treatment duration of 30 minutes, the samples cooled down to 250°C in approximately 1000 seconds.

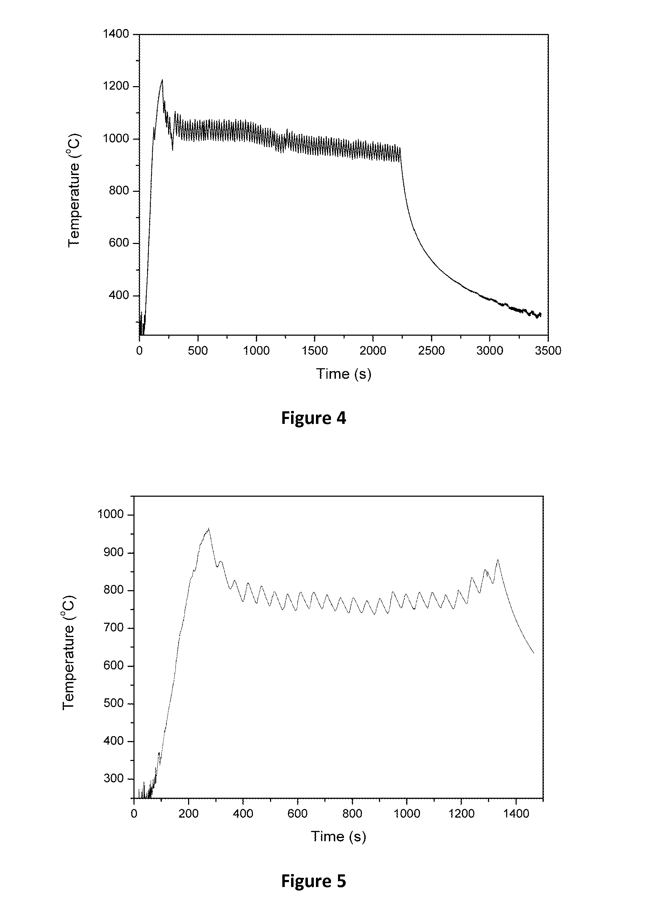

As shown in Fig.4, during the initial etching period, sample temperature reached to 930°C. With the initiation of bias cycles, average temperature dropped down to 750-800°C range and stayed constant throughout the treatment. Higher temperatures cannot be maintained using the ramped regime.

The XRD measurements for these samples also have the indication of η phase formation though only shallow peaks at 40.5978°, 43.9315° and 46.5923° were present. WC peaks were sharpened by using -1000 V bias which may be associated to crystallite growth (Fig.3b). The ramped bias mode with Cr bombardment allowed formation of n phase forms even at the low temperature range of 750-800°C.

## Example 3

### *Samples treated with Cr plasma using 12s -150V/9s -1000V staircase bias cycle for 30 minutes*

A different bias regime was applied in order to observe the effects of higher sample temperature during bias cycles. Using an Advanced Energy Pinnacle 12K power supply, bias was changed between low (-150V) and high (-1000V) voltages rapidly (from -150V to -1000V in 1 second and vice versa). Initial sample temperature at the end of the etching period was over 1200°C. Samples reached this temperature in 250 seconds. With the initialization of the bias cycles, average temperature dropped down to 1000-1100°C and slowly decreased to 900-1000°C range at the end of the treatment. Cooling down to 250° took place in 1250 seconds (Fig.4).

Among all the CAPT treatments used in this study, the clearest formation of n phase was achieved by this treatment (Fig.3d).

## Example 4

### *Samples treated with Al plasma using 30s -150V/30s -800V ramped bias cycle for 30 minutes*

During this treatment, sample temperatures reached around 970°C during the metal ion etching period, and then dropped to 700-800°C range. Near the end of the treatment, temperature increased gradually to 900°C (Fig.5). Eta phase formation was not observed in any of the Al plasma treated samples.

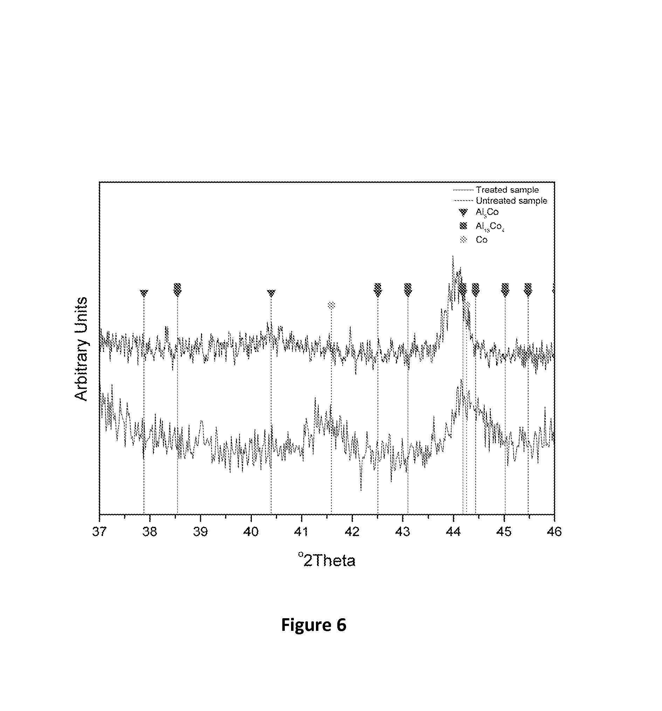

XRD measurements show the indication of possible formation of Al-Co intermetallics. There exist peaks in the XRD pattern that may be related to $Al_3Co$ and $Al_{13}Co_4$ phases (Fig.6). Also the peak belonging to Co in the untreated sample is observed to shift to the left (from 44.27° to 4.08°) with the treatment.

## Example 5

### *Corrosion testing*

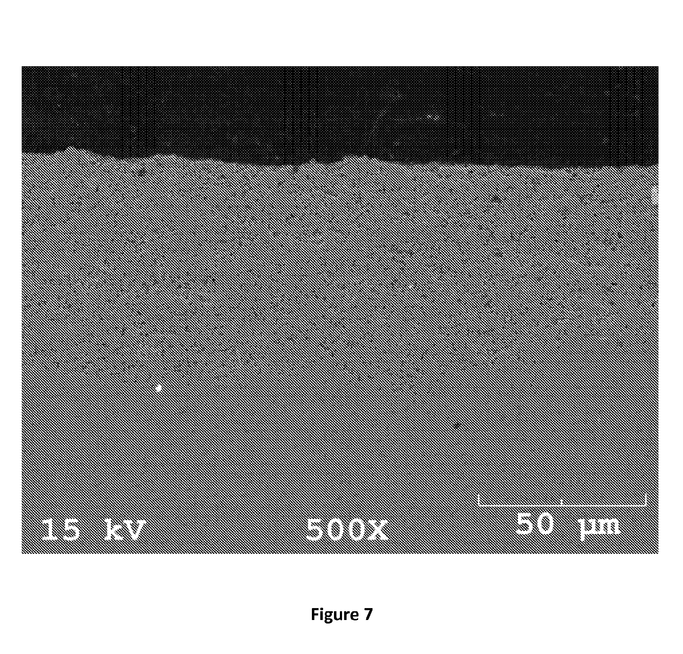

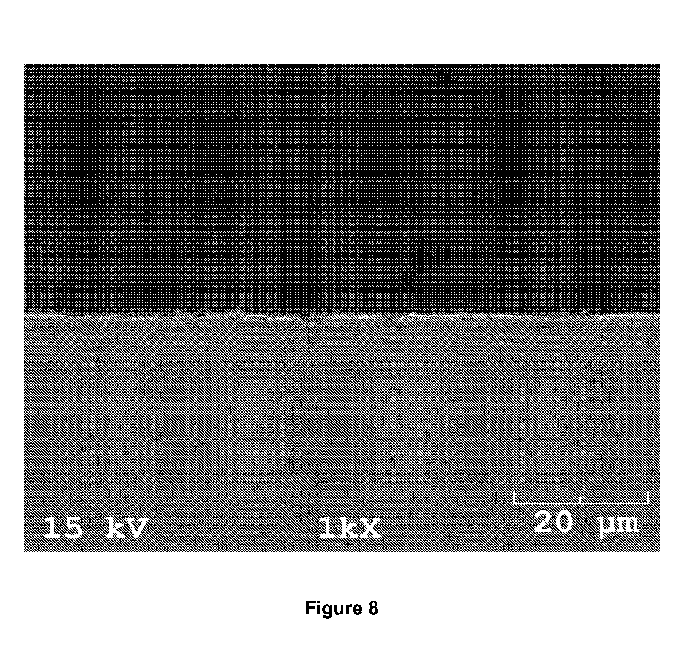

In order to test the corrosion behavior of the samples, CAPT treated and untreated samples were immersed in 5 vol.% $H_3PO_4$ containing 1g/l $Zn^{+2}$ for 24 hours at 50°C. Extent of corrosion damage was observed through cross sectional SEM investigations. Cr ion treated samples (sample treated with 12s 150V/9s 1000V staircase type bias cycles for 30 min.) with the highest η phase content with $M_{12}C$ phase structures showed increased resistance to the corrosive environment when compared to the untreated samples (Figure 7 and 8). In the untreated sample Co binder selectively dissolved, leaving behind the WC skeleton (Fig. 7). The depth of corrosion penetration was measured as 70-75 micrometers. On the other hand Cr plasma treated samples showed no indication of corrosion damage (Fig.8).

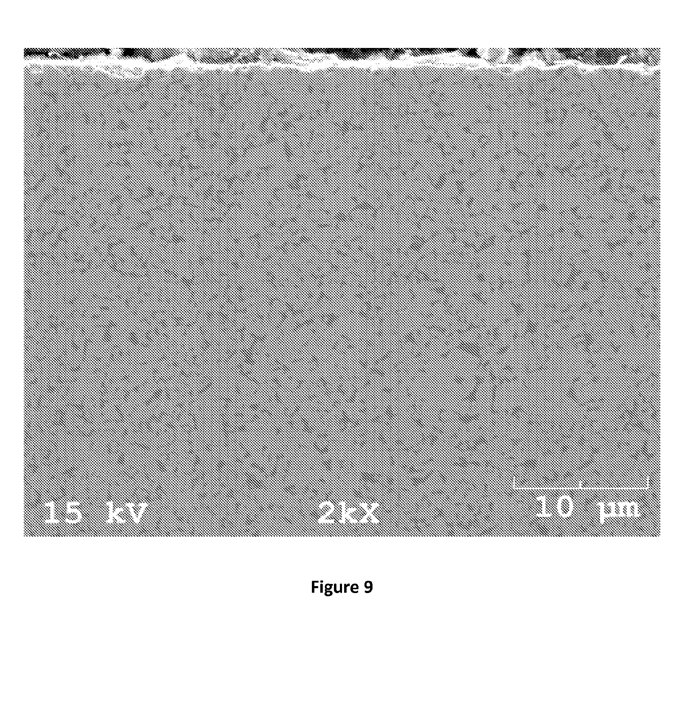

Samples treated with Al plasma also showed increased corrosion resistance. Cross sectional SEM observations revealed that corrosion damage was not present within Al plasma treated samples (Fig.9).

**Claims**

1. A method for producing a wear and corrosion resistant WC based structure comprising the steps of:

   treating a WC based substrate comprising a binder agent selected from the group consisting of Co, Ni and Mo, with a first type of treatment, said first type of treatment involving plasma application of a metal selected from the group consisting of Cr, Ti, Mo, Nb or alloys thereof, using an arc plasma treatment procedure, the procedure comprising deposition of said metal ions on the substrate surface by applying a low negative bias voltage ranging in between -1 to -300 V and then bombarding the substrate with said metal ions by changing the voltage to a higher bias value ranging from -500 to -1100 V, wherein the method comprises multiple cycles of low and high bias applications, or
   treating a WC based substrate with a second type of treatment, said second type of treatment involving plasma application of a metal selected from Al, Cu or alloys thereof, using an arc plasma treatment procedure, the procedure comprising deposition of said metal ions on the substrate surface by applying a low negative bias voltage ranging in between -1 to -300 V and then bombarding the substrate with said metal ions by changing the voltage to a higher bias value ranging from -500 to -1000 V, wherein the method comprises multiple cycles of low and high bias applications.

2. A method according to claim 1 wherein the low negative bias voltage of the first type of plasma treatment cycles is applied in a bias range of -50 to -150V while the high bias voltage of said first type of plasma treatment ranges from -900 to -1000V.

3. A method according to claim 1 wherein the low negative bias voltage of the second type of plasma treatment cycles is applied in a bias range of -50 to -150V while the high bias voltage of said second type of plasma treatment ranges from -650 to -800V.

4. A method according to claim 1 wherein the method further comprises the step of sputter cleaning and heating of the substrate prior to the metal deposition and bombardment cycles.

5. A method according to claim 2 wherein the first type of plasma treatment is carried out using 12s -150V/9s -1000V bias cycles for 30 minutes.

6. A method according to claim 1 wherein the bias adjustments are carried out through a computer enabling manual or automatized changes with preset bias values.

7. A method according to claim 1 wherein the cycles of bias voltages are applied with a pulse power supply.

8. A method according to claim 1 wherein the total treatment period of the cycles with low and high bias values ranges from 5 to 120 minutes.

9. A method according to claim 1 wherein the binder agent is Co such that substrate is a WC-Co based material.

10. A method according to claim 9 wherein the WC based substrate is a K20 grade material having about 10% Co content.

11. A method according to claim 1 wherein the WC based substrate further comprises carbides and/or carbonitrides selected from the group consisting of TiC, TaC, Mo2C, TiCN and (Ti,W)CN.

12. A method according to claim 1 wherein the fist type of treatment is carried out with Cr plasma application while the second type of treatment is carried out with Al plasma application.

**Patentansprüche**

1. Verfahren zum Erzeugen einer verschleißfesten und korrosionsbeständigen WC-basierten Struktur, das folgende Schritte aufweist:

   Behandeln eines WC-basierten Substrats, das ein Bindemittel aufweist, das aus der Gruppe ausgewählt ist, die aus Co, Ni und Mo besteht, mit einem ersten Behandlungstyp, wobei der erste Behandlungstyp eine Plasmaaufbringung eines Metalls beinhaltet, das aus der Gruppe ausgewählt ist, die aus Cr, Ti, Mo, Nb oder Legierungen daraus besteht, unter Verwendung eines Lichtbogenplasmabehandlungsprozesses, wobei der Prozess die Abscheidung der Metallionen auf der Substratoberfläche durch Anlegen einer niedrigen negativen Vorspannung im Bereich von -1 bis -300 V und ein anschließendes Beschießen des Substrats mit den Metallionen durch Ändern der Spannung auf einen höheren Vorspannungswert im Bereich von -500 bis -1100 V beinhaltet, wobei das Verfahren mehrere Zyklen der Anlegung von niedriger und hoher Vorspannung beinhaltet, oder

Behandeln eines WC-basierten Substrats mit einem zweiten Behandlungstyp, wobei der zweite Behandlungstyp eine Plasmaaufbringung eines Metalls beinhaltet, das aus Al, Cu oder Legierungen daraus ausgewählt ist, unter Verwendung eines Lichtbogenplasmabehandlungsprozesses, wobei der Prozess die Abscheidung der Metallionen auf der Substratoberfläche durch Anlegen einer niedrigen negativen Vorspannung im Bereich von -1 bis -300 V und ein anschließendes Beschießen des Substrats mit den Metallionen durch Ändern der Spannung auf einen höheren Vorspannungswert im Bereich von -500 bis -1000 V beinhaltet, wobei das Verfahren mehrere Zyklen der Anlegung von niedriger und hoher Vorspannung beinhaltet.

2. Verfahren nach Anspruch 1, wobei die niedrige negative Vorspannung vom ersten Typ von Plasmabehandlungszyklen in einem Vorspannungsbereich von -50 bis -150 V angelegt wird, während die hohe Vorspannung vom ersten Typ von Plasmabehandlung im Bereich von -900 bis -1000 V liegt.

3. Verfahren nach Anspruch 1, wobei die niedrige negative Vorspannung vom zweiten Typ von Plasmabehandlungszyklen in einem Vorspannungsbereich von -50 bis -150 V angelegt wird, während die hohe Vorspannung vom zweiten Typ von Plasmabehandlung im Bereich von -650 bis -800 V liegt.

4. Verfahren nach Anspruch 1, wobei das Verfahren ferner den Schritt des Sputterreinigens und Erwärmens des Substrats vor den Metallabscheidungs-und Beschießungszyklen beinhaltet.

5. Verfahren nach Anspruch 2, wobei der erste Typ von Plasmabehandlung unter Verwendung von 12s - 150V/9s -1000V Vorspannungszyklen 30 Minuten lang ausgeführt wird.

6. Verfahren nach Anspruch 1, wobei die Vorspannungsanpassungen durch einen Computer ausgeführt werden, der manuelle oder automatisierte Änderungen mit voreingestellten Vorspannungswerten ermöglicht.

7. Verfahren nach Anspruch 1, wobei die Zyklen von Vorspannungen mit einer Impulsleistungszufuhr angelegt werden.

8. Verfahren nach Anspruch 1, wobei der Gesamtbehandlungszeitraum der Zyklen mit hohen und niedrigen Vorspannungswerten im Bereich von 5 bis 120 Minuten liegt.

9. Verfahren nach Anspruch 1, wobei das Bindemittel Co ist, so dass das Substrat ein WC-Co-basiertes Material ist.

10. Verfahren nach Anspruch 9, wobei das WC-basierte Substrat ein Material der K20-Sorte mit ungefähr 10% Co-Gehalt ist.

11. Verfahren nach Anspruch 1, wobei das WC-basierte Substrat ferner Karbide und/oder Carbonitride aufweist, die aus der Gruppe ausgewählt sind, die aus TiC, TaC, Mo2C, TiCN und (Ti,W)CN besteht.

12. Verfahren nach Anspruch 1, wobei der erste Behandlungstyp mit Cr-Plasmaaufbringung ausgeführt wird, wohingegen der zweite Behandlungstyp mit Al-Plasmaaufbringung ausgeführt wird.

**Revendications**

1. Procédé de production d'une structure à base de CW résistante à l'usure et à la corrosion comprenant les étapes de :

traitement d'un substrat à base de CW comprenant un agent liant choisi dans le groupe constitué de Co, Ni et Mo, avec un premier type de traitement, ledit premier type de traitement impliquant une application au plasma d'un métal choisi dans le groupe constitué de Cr, Ti, Mo, Nb ou d'alliages de ceux-ci, en utilisant une procédure de traitement au plasma à arc, la procédure comprenant le dépôt desdits ions métalliques sur la surface du substrat en appliquant une basse tension de polarisation négative allant de -1 à -300 V et ensuite en bombardant le substrat avec lesdits ions métalliques en modifiant la tension à une valeur de polarisation plus élevée allant de -500 à -1 100 V, dans lequel le procédé comprend de multiples cycles d'applications de basses et hautes polarisations, ou

traitement d'un substrat à base de CW avec un second type de traitement, ledit second type de traitement impliquant une application au plasma d'un métal choisi parmi Al, Cu ou des alliages de ceux-ci, en utilisant une procédure de traitement au plasma à arc, la procédure comprenant le dépôt desdits ions métalliques à la surface du substrat en appliquant une basse tension de polarisation négative allant de -1 à -300 V et ensuite en bombardant le substrat avec lesdits ions métalliques en modifiant la tension à une valeur de polarisation plus élevée allant de -500 à -1 000 V, dans lequel le procédé comprend de multiples cycles d'applications de basses et hautes polarisations.

2. Procédé selon la revendication 1, dans lequel la basse tension de polarisation négative des cycles du premier type de traitement au plasma est appliquée dans une plage de polarisation de -50 à -150 V tandis que la haute tension de polarisation dudit premier type de traitement au plasma va de -900 à -1 000 V.

3. Procédé selon la revendication 1, dans lequel la basse tension de polarisation négative des cycles du second type de traitement au plasma est appliquée dans une plage de polarisation de -50 à -150 V tandis que la haute tension de polarisation dudit second type de traitement au plasma va de -650 à -800 V.

4. Procédé selon la revendication 1, dans lequel le procédé comprend en outre l'étape de nettoyage par pulvérisation et de chauffage du substrat avant les cycles de dépôt métallique et de bombardement.

5. Procédé selon la revendication 2, dans lequel le premier type de traitement au plasma est mis en oeuvre en utilisant des cycles de polarisation de 12 s -150 V/9 s-1 000 V pendant 30 minutes.

6. Procédé selon la revendication 1, dans lequel les ajustements de polarisation sont effectués par un ordinateur permettant des modifications manuelles ou automatisées par des valeurs de polarisation prédéfinies.

7. Procédé selon la revendication 1, dans lequel les cycles de tensions de polarisation sont appliqués à l'aide d'une alimentation en courant pulsé.

8. Procédé selon la revendication 1, dans lequel la période totale de traitement des cycles avec des valeurs de polarisation basses et hautes va de 5 à 120 minutes.

9. Procédé selon la revendication 1, dans lequel l'agent liant est le Co de telle sorte que le substrat soit un matériau à base de CW-Co.

10. Procédé selon la revendication 9, dans lequel le substrat à base de CW est un matériau de grade K20 ayant une teneur en Co d'environ 10 %.

11. Procédé selon la revendication 1, dans lequel le substrat à base de CW comprend en outre des carbures et/ou des carbonitrures choisis dans le groupe constitué de TiC, TaC, Mo2C, TiCN et (Ti,W)CN.

12. Procédé selon la revendication 1, dans lequel le premier type de traitement est mis en oeuvre par une application au plasma de Cr tandis que le second type de traitement est mis en oeuvre par une application au plasma de Al.

**Figure 1**

**Figure 2**

**Figure 3**

**Figure 4**

**Figure 5**

Figure 6

**Figure 7**

**Figure 8**

**Figure 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7384689 B
- US 6464748 B
- US 2009252973 A
- JP 63223104 B
- WO 2007121954 A

**Non-patent literature cited in the description**

- **O. ESA et al.** *International Journal of Refractory Metals & Hard Materials,* 2007, vol. 25, 286-292